# EUROPEAN PATENT APPLICATION

(11) **EP 4 693 376 A1**
(43) Date of publication of application: **11.02.2026**
(21) Application number: 24778903.5
(22) Date of filing: 22.02.2024
(51) Int. Cl.: H01L 21/3065, H01L 21/302

(54) **ETCHING METHOD AND ETCHING APPARATUS**

(30) Priority: 30.03.2023 JP 2023056162
(71) Applicant: Tokyo Electron Limited, Tokyo 107-6325 (JP)
(72) Inventor: NAKAGOMI, Ken, Yamanashi 4070192 (JP); IMAMURA, Kentaro, Yamanashi 4070192 (JP); IMAI, Yusuke, Yamanashi 4070192 (JP)
(74) Representative: Diehl & Partner
(86) International application number: PCT/JP2024/006520
(87) International publication number: WO 2024/202760

(57) **Abstract**

An etching method includes: exhausting a processing container in which a substrate is accommodated, the substrate including a first film, a porous film and a second film, each of the first film and the porous film being exposed from a surface of the substrate and the second film being not exposed from the surface of the substrate by being coated with the porous film; supplying, by a gas source, an etching gas having an etching property with respect to the first film and the second film to a gas supply path; storing the etching gas in a reservoir provided in the gas supply path to increase an internal pressure of the reservoir; and selectively etching the first film among the first film and the second film by opening a valve provided downstream of the reservoir to supply the etching gas stored in the reservoir into the processing container.

## Description

### TECHNICAL FIELD

The present disclosure relates to an etching method and an etching apparatus.

### BACKGROUND

When manufacturing a semiconductor device, a SiGe film formed on a surface of a semiconductor wafer (hereinafter referred to as a wafer) as a substrate may be etched. Patent Document 1 discloses supplying a HF gas and a ClF₃ gas to a wafer on which a stacked film of a Si film and a SiGe film is formed, thereby selectively etching the SiGe film of the stacked film.

### [Prior Art Documents]

### [Patent Documents]

Patent Document 1: Japanese Laid-Open Patent Publication No. 2018-170380

### SUMMARY

The present disclosure provides a technique capable of suppressing etching of a second film when etching a first film of a substrate on which the first film and the second film covered with a porous film are formed.

According to an embodiment of the present disclosure, an etching method includes exhausting a processing container in which a substrate is accommodated, wherein the substrate includes a first film, a porous film and a second film formed therein, each of the first film and the porous film being exposed from a surface of the substrate and the second film being not exposed from the surface of the substrate by being coated with the porous film; supplying, by a gas source, an etching gas having an etching property with respect to the first film and the second film to a gas supply path; storing the etching gas in a reservoir provided in the gas supply path to increase an internal pressure of an interior of the reservoir; and selectively etching the first film among the first film and the second film by opening a valve provided downstream of the reservoir in the gas supply path to supply the etching gas stored in the reservoir to the interior of the processing container.

According to the present disclosure in some embodiments, it is possible to provide a technique capable of suppressing etching of a second film when etching a first film of a substrate on which the first film and the second film covered with a porous film are formed.

### BRIEF DESCRIPTION OF DRAWINGS

FIG. 1 is a longitudinal sectional side view of a wafer subjected to an etching process according to an embodiment of the present disclosure.
FIG. 2A is a schematic view showing a change in shape of a wafer by an etching process in Comparative Example.
FIG. 2B is a schematic view showing the change in shape of the wafer by the etching process in Comparative Example.
FIG. 2C is a schematic view showing the change in shape of the wafer by the etching process in Comparative Example.
FIG. 2D is a schematic view showing the change in shape of the wafer by the etching process in Comparative Example.
FIG. 3 is a longitudinal sectional side view of the wafer after the etching process in Comparative Example.
FIG. 4A is a schematic view showing a change in shape of the wafer by the etching process of the present disclosure.
FIG. 4B is a schematic view showing the change in shape of the wafer by the etching process of the present disclosure.
FIG. 4C is a schematic view showing the change in shape of the wafer by the etching process of the present disclosure.
FIG. 4D is a schematic view showing the change in shape of the wafer by the etching process of the present disclosure.
FIG. 5 is a longitudinal sectional side view of the wafer after the etching process of the present disclosure.
FIG. 6 is a longitudinal sectional side view of an apparatus for performing the etching process according to an embodiment.
FIG. 7 is a timing chart showing the supply and cutoff of gases used in the etching process and changes in internal pressure of a processing space.
FIG. 8 is a graph showing results of an evaluation test.
FIG. 9 is a graph showing results of the evaluation test.
FIG. 10 is a longitudinal sectional side view showing a structure of a film on a substrate in the evaluation test.
FIGS. 11A and 11B are explanatory views of the evaluation test, which shows images of the film.

### DETAILED DESCRIPTION

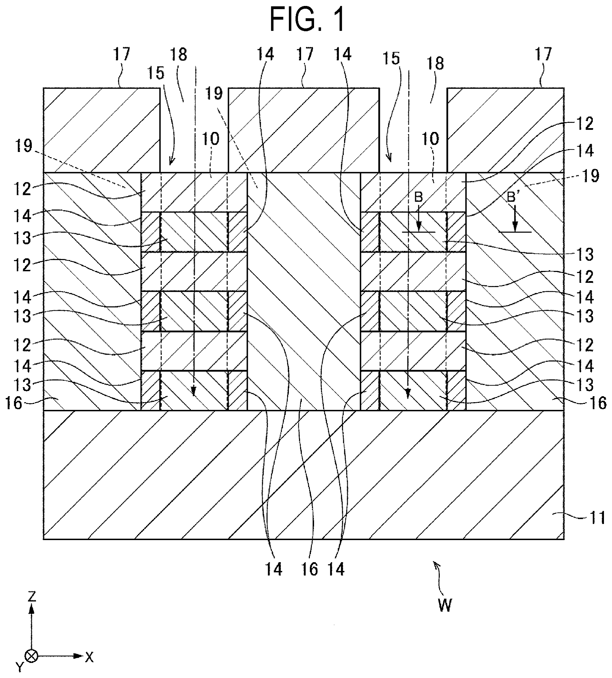

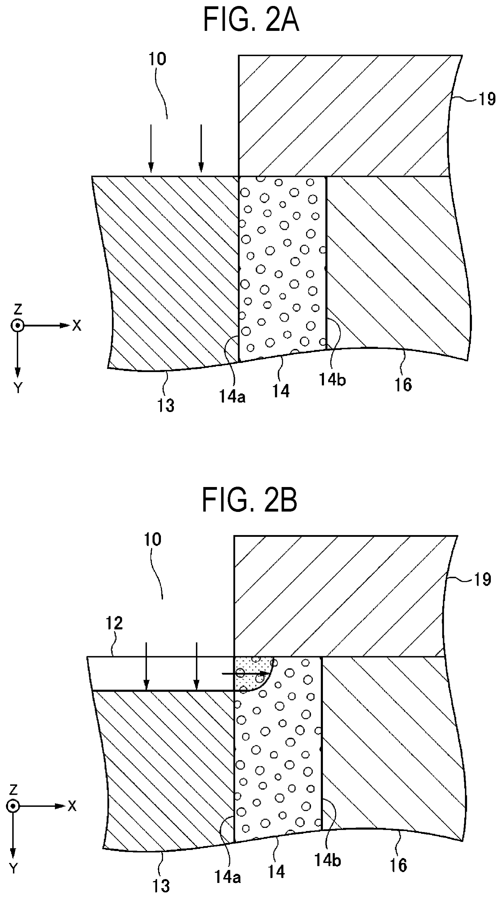

Prior to describing an embodiment of an etching method of the present disclosure, a structure of a film formed on a wafer W, which is a substrate to be etched, will be described with reference to FIGS. 1 and 2A. FIG. 1 is a longitudinal side view showing the film structure, and FIG. 2A is a transverse plan view taken along line B-B' in FIG. 1. In the figure, two mutually orthogonal directions in a plane direction of the wafer W are referred to as an X direction and a Y direction, and a thickness direction of the wafer W, which is orthogonal to both the X and Y directions, is referred to as a Z direction. In the following description, the wafer W is assumed to be placed horizontally, and the X direction may be referred to as a left-right direction, the Y direction as a front-rear direction, and the Z direction as a vertical direction.

A number of stacked bodies 15 each of which is composed of a Si (silicon) film 12, a SiGe (silicon germanium) film 13 which corresponds to a first film, and a porous film 14, are formed on a base film 11 formed on the wafer W. The SiGe film 13 of the stacked body 15 is a film to be etched. As described below, the etching gas is used to selectively etch the SiGe film 13 among the Si film 12 and the SiGe film 13. The plurality of stacked bodies 15 is provided at intervals in the front-rear and left-right directions, and are arranged in the form of a matrix in a plan view. The porous film 14 is, for example, an insulating film, more specifically, a low-k film composed of a silicon-containing film, such as SiOC (carbon-added silicon oxide) or SiOCN (a film composed of Si, oxygen, nitrogen, and carbon), other than SiGe. The porous film 14 has resistance to the etching gas (to be described later) used in the etching method of the present disclosure.

A structure of the aforementioned stacked body 15 will be further described. The porous film 14 is formed to be adjacent to left and right sides of the SiGe film 13. Thus, a direction in which the SiGe film 13 and the Si film 12 are aligned intersects a direction in which the SiGe film 13 and the porous film 14 are aligned. Assuming that the SiGe film 13 and the porous film 14 adjacent on the left and right sides of the SiGe film 13 are referred to as an adjacent body, the stacked body 15 is constituted by stacking a plurality of adjacent bodies and the plurality of Si films 12 one above another. The adjacent bodies and the Si films 12 are alternately positioned when viewed in the vertical direction (the Z direction). An upper end portion of the stacked body 15 is composed of the Si films 12 among the adjacent bodies and the Si films 12. A semiconductor film 16 corresponding to a second film is provided between the stacked bodies 15 arranged side by side. The stacked body 15 and the semiconductor film 16 are adjacent to each other. The semiconductor film 16 forms a source or drain of a semiconductor product manufactured from the wafer W and is composed of SiGe.

In addition, an upper layer film 17 is provided on the stacked body 15 and the semiconductor film 16. A plurality of grooves 18 extending in the front-rear direction is formed in the upper layer film 17 at intervals in the left-right direction so that the upper layer film 17 is divided into left and right portions. Each groove 18 is provided at a position overlapping the SiGe film 13 in the vertical direction (the Z direction). A lower portion of the upper layer film 17 extends between the stacked bodies 15 arranged in the front-rear direction to form an invaginated portion 19. The invaginated portion 19, and the Si film 12 and the SiGe film 13 of the stacked body 15 are formed as a sidewall of a recess 10. The recess 10 is connected to the groove 18. Thus, the Si film 12 and the SiGe film 13 as the sidewall of the recess 10 are exposed from the surface of the wafer W and are exposed to the etching gas supplied above the wafer W. The semiconductor film 16 is coated with the upper layer film 17 and is not exposed from the surface of the wafer W.

Although the description of detailed configurations is omitted, the upper layer film 17 is composed of multiple types of films, such as a silicon dioxide (SiO₂) film, an insulating film composed of SiOCN and the like. The upper layer film 17 has resistance to the etching gas, thereby preventing the semiconductor film 16 from being etched from above by the etching gas.

In the above-described film structure, the etching gas (indicated by a dashed-dotted arrow in FIG. 1) supplied above the wafer W flows into the recess 10 via the groove 18 so that a side surface of each SiGe film 13 on the side of the recess 10, which constitutes the sidewall of the recess 10, is etched in a direction away from the recess 10 in the front-rear direction. Further, the SiGe film 13 is adjacent to the semiconductor film 16 via the porous film 14. Thus, even when the SiGe film 13 is being etched, since the semiconductor film 16 is coated with the upper layer film 17 and the porous film 14, the semiconductor film 16 is not exposed from the surface of the wafer W. However, during this etching, the etching gas may pass through pores of the porous film 14, penetrate the porous film 14, and be supplied to the semiconductor film 16.

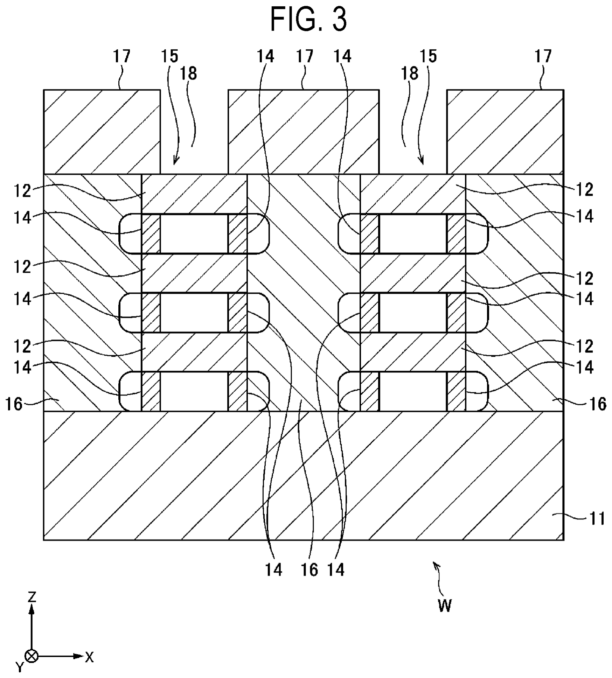

Hereinafter, an etching method in Comparative Example, which is different from the etching method of the present disclosure, will be described with reference to FIGS. 2A to 2D and 3. FIGS. 2A to 2D schematically illustrate a state in which the etching method in Comparative Example proceeds. In FIGS. 2B to 2D, a portion of the porous film 14 into which the etching gas has permeated is indicated by dots. FIG. 3 is a longitudinal side view showing the same place as that in FIG. 1, which shows a film structure after an etching process in Comparative Example is performed. In Comparative Example, the etching gas is not stored in a tank of the present disclosure (to be described later). Instead, the etching gas supplied from a gas source is supplied into a processing container at a predetermined flow rate via a flow rate adjustment mechanism such as a mass flow controller. Thus, the SiGe film 13 of the wafer W accommodated in the processing container is etched. The interior of the processing container is exhausted to be kept in a vacuum atmosphere at a predetermined pressure.

There is known that an etching amount is increased with an increase in a supply time of the etching gas. In view of this point, in the etching method in Comparative Example, an etching time sufficient to completely etch the SiGe film 13 is set and the etching gas is continuously supplied to a processing space 21 kept in a vacuum atmosphere for the set etching time. By the etching gas introduced into the recess 10, the SiGe film 13 is etched from a state shown in FIG. 2A in a lateral direction (the Y direction) as shown in FIG. 2B. Since FIGS. 2A to 2D are shown as the plan views, the SiGe film 13 is illustrated to be etched from top to bottom. As shown in FIG. 2B, the porous film 14 is exposed by such an etching process. The etching gas flows into the exposed porous film 14 from a side surface 14a on the side of the SiGe film 13. The etching gas passes through the porous film 14 from the side surface 14a toward a side surface 14b on the side of the semiconductor film 16.

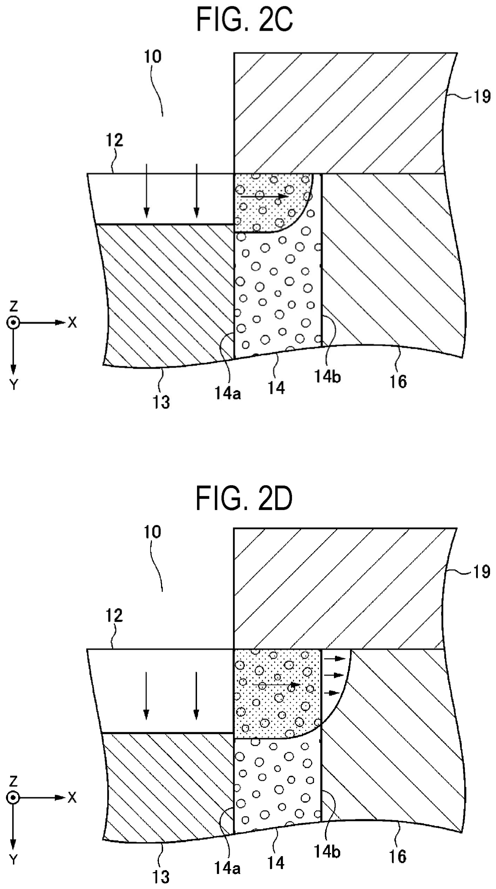

As shown in FIG. 2C, along with the lapse of the gas supply time, the etching gas further flows toward the semiconductor film 16. As described above, the semiconductor film 16 is made of SiGe, and the etching gas has an etching property with respect to both the SiGe film 13 and the semiconductor film 16. Thus, when the etching gas reaches the semiconductor film 16, the semiconductor film 16 may be etched as shown in FIG. 2D. FIG. 3 shows the wafer W after being subjected to the etching process in the case in which the semiconductor film 16 has been laterally etched via the pores of the porous film 14. Hereinafter, a distance that the etching gas passes through the porous film 14 from the side surface 14a on the side of the SiGe film to the side surface 14b on the side of the semiconductor film16 may be sometimes referred to as an etching gas passing distance, or simply a passing distance.

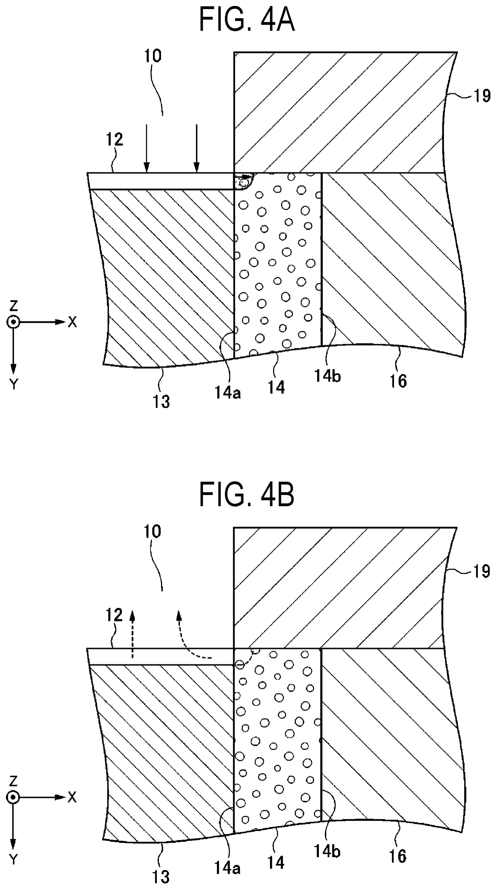

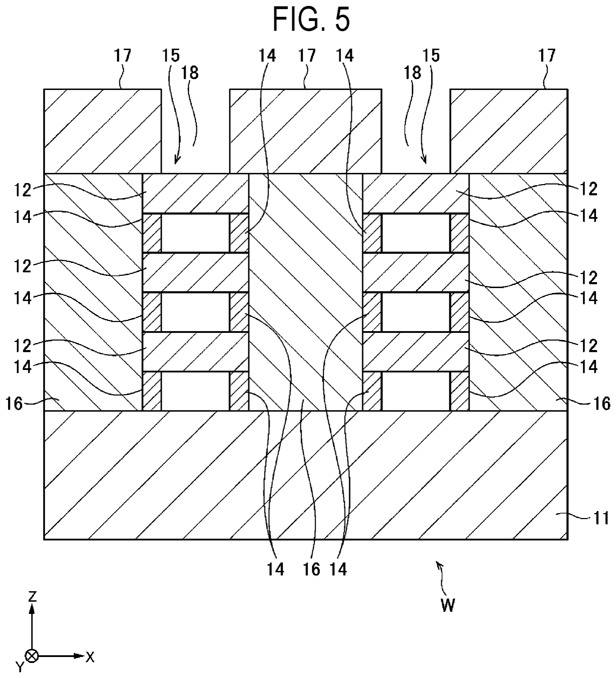

The etching method of the present disclosure will be described with reference to FIGS. 4A to 4D and FIG. 5. FIGS. 4A to 4D show a change in shape of the wafer W when being subjected to the etching process of the present disclosure. As in FIGS. 2B to 2D, in FIGS. 4A to 4D, a portion of the porous film 14 into which the etching gas has permeated is indicated by dots, and the etching is illustrated to proceed from above in terms of the Z direction. In the etching method of the present disclosure, similar to the etching method in Comparative Example, the wafer W is accommodated in the processing container kept in the vacuum atmosphere of the predetermined pressure through the exhaust. However, the etching gas supplied from the gas source is supplied to a flow path in which a tank and a valve are disposed sequentially toward a downstream side. A downstream end of the flow path is connected to the processing container. Specifically, the etching gas is supplied to the tank with the valve closed. The etching gas in a pressurized state rapidly diffuses inside the recess 10 when the valve is open. Thus, the etching gas may substantially uniformly adhere to each SiGe film 13 with little time lag. As a result, the etching process as shown in FIG. 4A proceeds.

Further, after the valve is opened, the valve is quickly closed to stop the supply of the etching gas into the processing container. In this way, the etching gas is supplied in a relatively short time. Thus, as shown in FIG. 4A, the etching gas passing distance in the porous film 14 is shorter than that in Comparative Example. This prevents the etching gas from reaching the semiconductor film 16. The etching gas that has flowed into the porous film 14 is removed by exhausting the interior of the processing container.

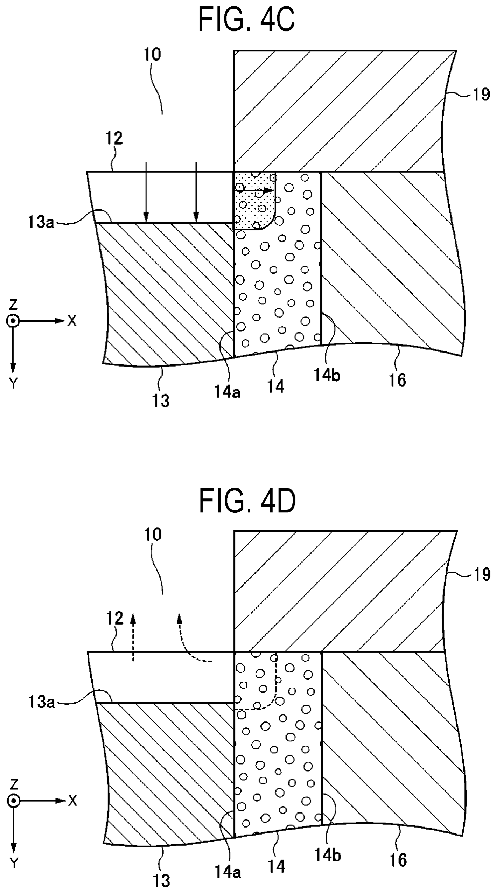

The etching process proceeds by repeating a cycle including pressurizing by the supply of the etching gas with the valve closed, opening of the valve, and exhausting the interior of the processing container after the valve is opened. FIGS. 4A and 4B show a first round of etching process, and FIGS. 4C and 4D show a second and subsequent rounds of etching processes. As shown in evaluation tests to be described later, the etching amount is considered to increase in proportion to the number of cycles performed. Further, as the etching of the SiGe film 13 proceeds with each etching process (number of cycles), the exposed range of the side surface 14a of the porous film 14 increases. Thus, the amount of etching gas remaining in the porous film 14 immediately after the supply of the etching gas is stopped (immediately after the valve is closed) is increased. However, since the expanding exposed range of the side surface 14a serves as a flow path for the etching gas during desorption, the desorption of the etching gas is also effective. In other words, even if the area of the exposed porous film 14 increases as the etching process for the SiGe film 13 proceeds in the Y direction, the passing distance of the etching gas is reduced at each position in the Y direction. In this manner, the SiGe film 13 among the semiconductor film 16 and the SiGe film 13 may be selectively etched. FIG. 5 shows a state of the wafer W after the SiGe film 13 has been completely removed and the etching process has been completed.

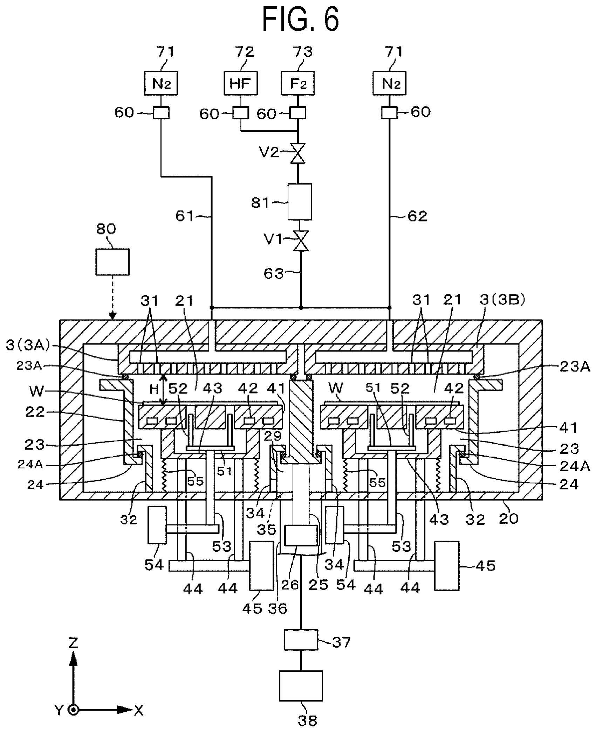

Next, as an embodiment of an etching apparatus according to the present disclosure, an etching apparatus 1 for carrying out the etching method described with reference to FIGS. 4A to 5, will be described with reference to a longitudinal side view of FIG. 6. In the etching apparatus 1, a circular substrate, that is, the wafer W, is accommodated in the processing container 20, the interior of the processing container 20 is kept in a vacuum atmosphere of a desired pressure within, and a halogen-containing gas as the etching gas is supplied into the processing container 20 to perform the etching process. Specifically, in this example, a mixed gas of a HF (hydrogen fluoride) gas and a F₂ (fluorine) gas, which are fluorine-containing gases, is supplied as the halogen-containing gas to a tank 81 at a flow rate ratio of, for example, 1:20. A temperature of the wafer W is adjusted to, for example, -20 degrees C to 150 degrees C. during the etching process, no plasma is formed around the wafer W.

A configuration of the etching apparatus will be described in detail below. Two wafers W are accommodated side by side in the processing container 20. The two wafers W are etched at the same time. The wafers W are processed in processing spaces 21 that are partitioned from each other. A processing space forming member 22 is provided inside the processing container 20 to form the processing spaces 21. The processing space forming member 22 is configured such that vertically-open through-holes 23 are formed to be spaced apart from each other on left and rights of a horizontally elongated block. Lower edges of the circumferential surface forming the through-holes 23 form inwardly-protruded edge portions 24.

A lower central portion of the processing space forming member 22 is connected to an elevating mechanism 26 installed outside the processing container 20 via a support pillar 25 that penetrates a bottom wall of the processing container 20. The processing space forming member 22 may be raised and lowered between upper and lower positions in the interior of the processing container 20. A bellows (not shown) configured to surround the support pillar 25 is installed outside the processing container 20. Thus, a gap between the support pillar 25 and the bottom wall of the processing container 20 when the support pillar 25 is raised and lowered is sealed.

Two shower plates 3, which are circular in a plan view, are installed on a ceiling of the processing container 20. The two shower plates 3 are located above the through-holes 23 in the processing space forming member 22. The two shower plates 3 may be indicated by numeral references 3A and 3B to be distinguished from each other. A gas supplied to the center of each shower plate 3 via each pipe (to be described below) is discharged downward from a large number of discharge ports 31 formed in a dispersed manner in a lower surface of each shower plate 3 via a flow path of the shower plate 3.

Upright cylindrical bodies 32 are provided on left and right sides of the bottom wall of the processing container 20, respectively. When the processing space forming member 22 is positioned at the upper position, an O-ring 23A provided on an edge of each through-hole 23 is brought into close contact with a peripheral edge portion of the lower surface of the shower plate 3. Further, an O-ring 24A provided on the protruded edge portion 24 is brought into close contact with a flange formed on an upper edge portion of each cylindrical body 32. This forms the processing spaces 21 described above. The processing space 21 is a region above a stage 41 (to be described later) in a space surrounded by the processing space forming member 22 and the shower plate 3.

A through-hole 34 is formed in the sidewall of the cylindrical body 32. An exhaust port 35 opens at a position away rearward from the support pillar 25 in the central portion of the bottom wall of the processing container 20 in the left-right direction. An exhaust pipe 36 with an open upstream end is connected to the exhaust port 35 outside the bottom wall. A downstream end of the exhaust pipe 36 is connected to an exhaust mechanism 38 including a vacuum pump or the like via a valve 37. An internal pressure of the processing space 21 is adjusted by adjusting an opening degree of the valve 37. The exhaust pipe 36 corresponds to an exhaust path, and the valve 37 corresponds to an exhaust valve provided in the exhaust path.

When the processing space forming member 22 is positioned at the lower position, a transfer port (not shown) provided in front of the processing container 20 is located above the processing space forming member 22. A wafer transfer mechanism provided outside the processing container 20 is located above the through-hole 23 via the transfer port. The wafer W may be delivered to and from the stage 41 (to be described) via pins 52 (to be described).

The stage 41 is provided in each through-hole 23. An upper surface of the stage 41 is horizontal and faces the lower surface of the shower plate 3. In a plan view, the central portion of the shower plate 3 is aligned with the center of the wafer W placed on the upper surface of the stage 41. The stage 41 is formed with a fluid flow path 42 through which a temperature-controlled fluid is supplied so that the temperature of the wafer W on the stage 41 is adjusted to a desired temperature. A partition member 43, which is concave in a vertical cross-sectional view to be connected to the lower surface of the stage 41, is provided. By the partition member 43, a partitioned space is formed below the stage 41.

The partition member 43 is connected to an elevating mechanism 45 installed outside the processing container 20 via a support pillar 44 extending downward from the bottom wall of the processing container 20 so that a height of the stage 41 may be adjusted. Thus, by changing a height H between the stage 41 and the shower plate 3 during processing of the wafer W, the volume of the processing space 21 may be changed.

Three pins 52 (only two are shown in FIG. 6) extending vertically upward are supported by support plates 51 installed in a space formed by the partition member 43 and the lower surface of the stage 41. Each support plate 51 is connected to an elevating mechanism 54 installed outside the processing container 20 via a support pillar 53 extending downward through the partition member 43 and the bottom wall of the processing container 20. The pins 52 may be moved upward or downward from the upper surface of the stage 41 so that the wafer W is transferred between the transfer mechanism and the stage 41 as described above. In the figure, reference numeral 55 denotes the bellows that surrounds the support pillars 44 and 53 and connects the partition member 43 to the bottom wall of the processing container 20. The bellows 55 prevents the airtightness of the processing container 20 from breaking due to a gap between the support pillars 44 and 53 and the bottom wall.

The etching apparatus 1 includes pipes 61, 62, and 63. The pipes 61, 62, and 63 are connected to the ceiling of the processing container 20 so as to supply a gas from above to the centers of the shower plates 3A and 3B, respectively. Upstream sides of the pipes 61 and 62 are connected to a N₂ gas source 71 via a flow rate adjusting mechanism 60. The flow rate adjusting mechanism 60 includes a valve and a mass flow controller, switches the supply and cutoff of the gas to the downstream side of the flow path and adjusts a flow rate of the gas. A N₂ (nitrogen) gas supplied from the N₂ gas source 71 serves as a carrier gas for the etching gas and as a purge gas for purging the interior of the processing container 20. The N₂ gas is constantly supplied from the gas source 71 during processing of the wafer W.

The pipe 63 is configured as a gas supply path in which the reservoir is provided. The pipe 63 includes a valve V1, a tank 81, and a valve V2 provided sequentially toward the upstream side. The pipe 63 is branched into two paths on the upstream side of the valve V2. One path is connected to a HF gas source 72 via the flow rate adjusting mechanism 60, and the other path is connected to a F₂ gas source 73 via the flow rate adjusting mechanism 60. The valve V2 is opened while each gas is supplied to and stored in the tank 81 as the reservoir, and is closed to prevent the gas stored in tank 81 from flowing backward through the pipe 63 while the valve V1 as a first valve is opened.

The etching apparatus 1 includes a controller 80, which is a computer. The controller 80 includes software, a memory, and a CPU. A program incorporates instructions (steps) for implementing the processing of the wafer W, which will be described below. This program is stored in a storage medium, such as a compact disc, a hard disk, a magneto-optical disc, a DVD, or the like, and is installed on the controller 80. The controller 80 outputs control signals to individual constituent elements of the etching apparatus 1 to control operations of the individual constituent elements. Specifically, various operations, such as the discharge of the gas from the tank 81 by the opening/closing of the valves V1 and V2, the supply of the gas to the tank 81, the adjustment of the flow rate of the gas supplied to the downstream side by the flow rate adjusting mechanism 60, the elevation of the processing space forming member 22, the stage 41, and the pins 52 by the elevating mechanisms 26, 45, and 54, and the adjustment of the opening degree of the valve 37 are controlled by the control signals.

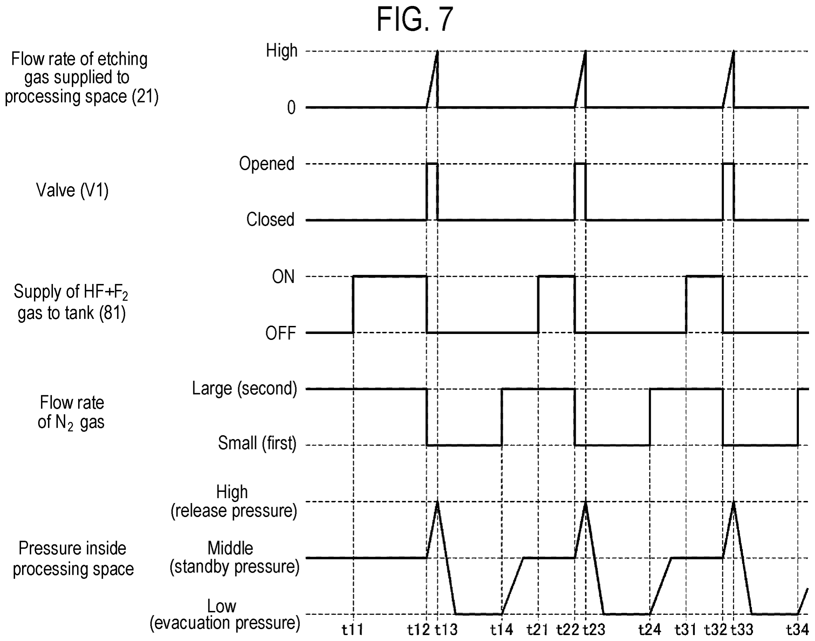

Next, an example of the operation of the etching apparatus 1 of this embodiment will be described in detail with reference to FIG. 6 showing the configuration of the apparatus, FIGS. 4A to 4D showing the change in shape of the wafer W as described above, and FIG. 7 showing a timing chart. The timing chart of FIG. 7 shows the flow rate of the etching gas supplied to the processing space 21, the timing of opening/closing of the valve V1, the timing of the supply of the HF gas and the F₂ gas to the tank 81, the change in flow rate set for the N₂ gas supplied to the processing space 21, and the change in internal pressure of the processing space 21. In the chart, which shows repeated etching processes, times in an n-th round of etching process are indicated by times tn1 to tn4. During the operation of the etching apparatus 1, the pressure of the processing space 21 is set to, for example, a pressure in a range of 0.133Pa to 666Pa.

As shown in FIG. 6 , in a state where the processing space forming member 22 is positioned at the lower position, two wafers W are transferred from outside the processing container 20 to above each stage 41 by a transfer mechanism (not shown). Thereafter, each wafer W is placed on the stage 41 via the pins 52 and is adjusted to the temperature described above. Subsequently, the processing space forming member 22 is positioned at the upper position to form the processing space 21 inside the processing container 20. Further, the stage 41 is positioned at a predetermined height so that the height H between the stage 41 and the lower surface of the shower plate 3 is set to the magnitude described above. In a state where the N₂ gas is supplied from the gas source 71 into the processing container 20 at a second flow rate, the valve 37 is opened to a predetermined opening degree (first opening degree), and the processing space 21 is set to have a preset standby pressure.

With the valve V1 closed, the valve V2 is opened. As a result, the HF gas and the F₂ gas are supplied to the tank 81 from the gas sources 72 and 73, and the internal pressure of the tank 81 increases from an initial pressure (time t11 in the chart). In other words, a process of pressurizing the etching gas is performed. Then, when the internal pressure of the tank 81 reaches a preset gas release pressure, the valve V2 is closed and the valve V1 is opened so that the flow rate of the etching gas supplied to the processing space 21 is rapidly increased from zero. While the valves are opened/closed in this manner, the flow rate of the N₂ gas supplied to the processing space 21 is reduced to a first flow rate by the flow rate adjusting mechanism 60 (time t12 in the chart).

Since the pressurized etching gas in the tank 81 is released into each processing space 21 all at once, the internal pressure of the processing space 21 is increased, and the etching gas rapidly diffuses throughout the processing space 21. Then, as described above, the pressurized etching gas diffuses from top to bottom inside the recess 10 in a relatively short time and is supplied to each SiGe film 13. As a result, each SiGe film 13 is removed by approximately the same amount, and the etching gas flows into the pores of the porous film 14 (FIG. 4A).

Then, at time t13, which is, for example, one second or less after time t12, the valve V1 is closed to stop the supply of the gas from the tank 81 to each processing space 21. At this time, not all of the gas in the tank 81 is released into the processing space 21, and some remains. In addition, at time t13, the opening degree of the valve 37 is changed to a predetermined second opening degree greater than the first opening degree, and the internal pressure of the processing space 21 is reduced to a pressure (evacuation pressure) lower than the standby pressure. This desorbs the etching gas adhering to the surface of the wafer W so that the etching process is stopped and the etching gas is desorbed from the porous film 14 (FIG. 4B).

Next, the opening degree of the valve 37 is changed to the first opening degree so that the internal pressure of the processing space 21 is increased to return to the standby pressure and the flow rate of the N₂ gas is increased to return to the second flow rate (time t14). Then, in order to supply a pressurized etching gas for the second round of etching process, at time t21 after a predetermined time has elapsed after the adjustment to the standby pressure, the valve V2 is opened in the same manner as at time t11, and the internal pressure of the tank 81 is increased again by the supplied etching gas. At time t22, in the same manner as at time t12, the valve V2 is closed, the valve V1 is opened, and the flow rate of the N₂ gas is changed to the first flow rate. At time t23, in the same manner as at time t13, the valve V1 is closed, and the valve 37 for exhaust is changed to the second opening degree. At time t24, in the same manner as at time t14, the internal pressure of the processing space 21 is changed to the standby pressure, and the flow rate of the N₂ gas is changed to the second flow rate. For times tn1 to tn4, the operation of the etching apparatus 1 when n is 3 or greater is the same as the operation when n is 2. Thus, the operation of the etching apparatus 1 from times t31 to t33 shown in the chart is the same as the operation thereof from times t21 to t23. By performing the operation in this manner, the etching proceeds as shown in FIGS. 4C and 4D.

Times required to fill the tank 81 with the etching gas in a second and subsequent rounds of etching processes (time t21 to time t22, time t31 to time t32) is shorter than those required to fill the tank 81 with the etching gas in the first round of etching process (time t11 to time t12). This is because the valve V1 is quicky closed and the gas remains in the tank 81, and the tank 81 is filled with a gas corresponding to the amount of the gas released from the tank 81. Except for a difference in the filling time of the etching gas between the first round of etching process and subsequent rounds of etching processes, the etching apparatus repeats the same cycle of operations. During one cycle, the operations described from time t11 to t14, such as the opening/closing of the valves V1 and V2, the change in the opening degree of the valve 37, the supply of the gas to the tank 81, and the change in the amount of the N₂ gas supplied, are performed. This cycle is repeated in this manner, which makes it possible to selectively etch each SiGe film 13 while suppressing the etching of the semiconductor film 16 (FIG. 5). Then, each wafer W is unloaded from the processing container 20 in the reverse order of the loading procedure.

As described above, according to this method, the etching gas stored and pressurized in the tank 81 is released and quickly diffused throughout the processing space 21, so that the etching gas is supplied to the entire surface of the SiGe film on the wafer W. Thus, as described above, the valve V1 may be closed in a relatively short time, for example, one second or less, after opening the valve V1, which makes it possible to stop the supply of the etching gas to the processing space 21 and remove the etching gas from around the wafer W by the exhaust of the processing space 21. Thus, while etching the SiGe film 13, it is possible to suppress the supply of the etching gas to the semiconductor film 16 via the pores of the porous film 14.

Further, in the processing example described with reference to FIG. 7, the opening degree of the valve 37 is changed so that a period during which the valve 37 for exhaust is set to the evacuation pressure shown in FIG. 7 is set from time t13 to time t14, and the pressure during this period is set to be lower than the pressure when the valve V1 is opened (the pressure at times t12 and t22). That is, the internal pressure of the processing space 21 during the period from when the valve V1 is closed to when the valve V1 is next opened (time t13 to time t14) is set to be lower than the internal pressure of the processing space 21 at times t12 and t22 when the valve V1 is opened. This allows the etching gas to remain in the processing space 21 for a relatively long time during and immediately after the supply of the etching gas, thereby preventing a decrease in the etching rate. This also more reliably prevents the semiconductor film 16 from being etched due to the etching gas remaining around the wafer W for a long time.

Further, by setting the flow rate of the N₂ gas as an inert gas to a relatively high second flow rate until the valve V1 is opened and to a relatively low first flow rate after the valve V1 is opened, it is possible to suppress a decrease in the etching rate due to the dilution of the etching gas with the N₂ gas during the supply of the etching gas. Further, by increasing the flow rate of the N₂ gas from the first flow rate to the second flow rate until the valve V1 is opened, it is possible to promote purging of the processing space 21, more reliably suppress the etching of the semiconductor film 16, and adjust the internal pressure of the processing space 21 to the standby pressure. Further, the inert gas is not limited to the N₂ gas, but other gases such as an Ar (argon) gas may be used as the inert gas.

The number of repetitions of the cycle is optional. Further, when the required etching amount is small, the cycle may be performed only once without repetition, or may be repeated several times. Further, a film structure of the substrate to be etched is not limited to the example described above. While the SiGe film 13 (the first film), the porous film 14, and the semiconductor film 16 (the second film) are illustrated to be arranged side by side, for example, in the left-right direction along the surface of the wafer W, the arrangement direction of these films is arbitrary and these films may be arranged, for example, in the up-down direction. Further, the first film to be etched, the porous film, and the second film not to be etched are not limited to being arranged in this order. For example, the first film may be formed on the wafer W, the second film and the porous film may be formed at a position spaced apart from the first film, and the second film may be coated with the porous film.

In the present disclosure, the mixed gas of the F₂ gas and the HF gas is used as the etching gas to selectively etch the SiGe film 13 relative to the Si film 12 exposed from the surface of the wafer W, but the present disclosure is not limited thereto. The etching gas may be appropriately selected according to a film to be etched. For example, in a case where a film to be etched is a Si film instead of the SiGe film 13, the semiconductor film 16 is also composed of silicon, and the Si film, the porous film 14, and the semiconductor film 16 are arranged in this order, the above-described etching apparatus 1 may be used to etch the Si film without having to etch the semiconductor film 16. That is, in this example, both the first film to be etched and the second film not to be etched are silicon-containing Si films. In such a case, an etching gas composed of a fluorine-containing gas, such as a F₂ gas, and a basic gas may be used instead of the mixed gas of the HF gas and the F₂ gas. As used herein, the expression "a gas or film contains a certain component" does not mean that the component is contained as a major component rather than being contained as an impurity.

Specifically, the above-mentioned basic gas is an ammonia (NH₃) gas and/or an amine gas such as a trimethylamine (TMA) gas. To supply the basic gas into the processing container 20, the above-described etching apparatus 1 includes the pipe (the gas supply path) equipped with the tank, the valves provided on upstream and downstream sides of the tank, and the flow rate adjusting mechanism 60, and the basic gas is supplied from the gas source to the processing space 21 via the pipe. In other words, the basic gas is supplied into the processing container 20 in the same manner as that of the F₂ gas using a tank or the like installed in a separate line. The reason why the fluorine-containing gas and the basic gas are stored in separate tanks is to prevent these gases from reacting with each other when they are supplied into the same tank 81. Alternatively, the first film to be etched may be silicon oxide (SiOₓ) or the like. When byproducts are formed during each etching process, they may be sublimated by lowering the internal pressure of the processing space 21 during the supply of the etching gas.

Further, the semiconductor film 16 may be a SiGe film doped with boron. Hereinafter, such a boron-doped SiGe film may be referred to as a B-SiGe film. As will be explained in detail in the section of the evaluation test to be described below, test results have been obtained that the etching technique of the present technique may more reliably suppress the etching of the semiconductor film 16 while selectively etching the SiGe film 13. The configuration of the etching apparatus 1 may be appropriately changed without departing from the spirit and scope of the present technique. Specifically, for example, a flow path system for supplying the etching gas may be appropriately changed. Although an example in which the valve V2 is provided on the upstream side of the tank 81 has been shown, the valve V2 may be omitted. Further, the supply flow rate of the N₂ gas during the processing of the wafer W is not limited to the transition shown in the chart of FIG. 7. For example, the supply flow rate of the N₂ gas may be constant during the processing of the wafer W.

The embodiments disclosed herein are illustrative in all respects and should be considered not limiting. The above-described embodiments may be omitted, substituted, modified, or combined in various ways without departing from the spirit and scope of the appended claims.

### [Evaluation Test 1]

Evaluation tests conducted in relation with the technique disclosed herein are described below.

In Evaluation Test 1-1, the technique described as an etching method in Comparative Example with respect to this embodiment was used to perform an etching process on a SiGe film formed on a substrate. This SiGe film does not have the film structure described with reference to FIG. 1 and the like, but is a flat film formed on the surface of a flat substrate. In Evaluation Test 1-1, the flow rates of the etching gas and the N₂ gas supplied into the processing container during the etching process were set to be constant, and the internal pressure of the processing container during the etching process was also set to be constant. The etching time (the supply time of the etching gas) was varied for each substrate, and the relationship between the etching time and the etching amount of the SiGe film was examined.

In Evaluation Test 1-2, the etching process described with reference to the chart in FIG. 7 was performed. A substrate with a flat SiGe film formed thereon was used as the substrate to be processed, as in Evaluation Test 1-1. Then, the number of executions of the cycle including opening/closing the valve V1 was varied for each substrate, and the relationship between the number of cycles and the etching amount was examined.

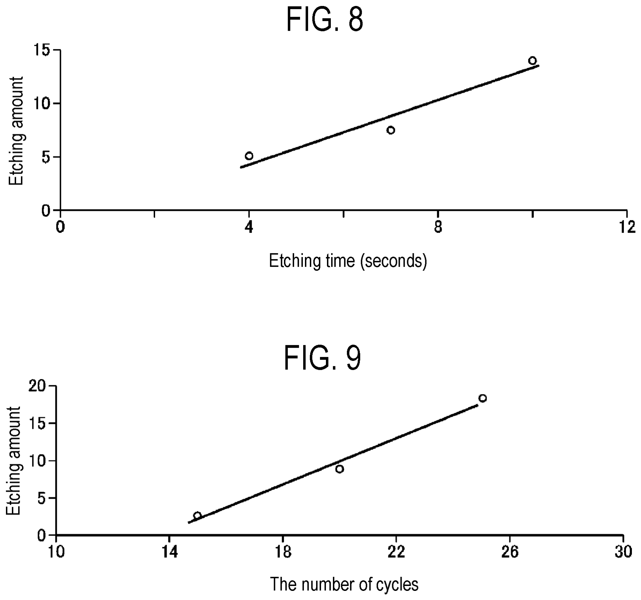

FIG. 8 shows the results of Evaluation Test 1-1, and FIG. 9 shows the results of Evaluation Test 1-2. The vertical axis of each graph in FIGS. 8 and 9 represents the etching amount, which is a normalized value by dividing a measured value by a predetermined number. The larger the normalized value, the greater the etching amount. As shown in FIG. 8, in Evaluation Test 1-1, a linear relationship was observed between the etching amount and the etching time, and the longer the etching time, the greater the etching amount. That is, it is clear that the amount of etching may be controlled by the etching time.

Meanwhile, as shown in FIG. 9, In Evaluation Test 1-2, a linear relationship was also observed between the etching amount and the number of repetitions of the cycle, the larger the number of repetitions of the cycle, the greater the etching amount. Thus, it was confirmed that the etching amount of the present disclosure may be controlled to the same extent as the etching method in Comparative Example by adjusting the number of repetitions of the cycle. While this test involves etching the flat film, it is believed that the etching amount may be similarly controlled according to the number of cycles when etching the film structure shown in FIG. 1.

### [Evaluation Test 2]

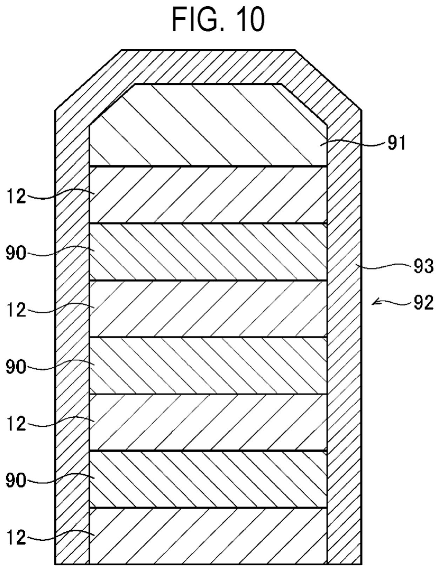

In Evaluation Test 2, a substrate having a film structure shown in FIG. 10 was prepared. This film structure includes a stacked body 92 in which Si films 12 and SiGe films 90 are alternately stacked upward one above another and a SiN (silicon nitride) film 91 is formed on the uppermost Si film 12. A low-k porous film 93 is formed to cover the stacked body 92 from side to top and is exposed from the surface of the substrate. In other words, the porous film 93 is exposed to an etching gas when the etching gas is supplied.

In Evaluation Test 2-1, the substrate was subjected to the etching process in the same manner as in Evaluation Test 1-1, and an SEM image was taken to observe the state of the SiGe film 90 after etching. In Evaluation Test 2-2, the substrate was subjected to the etching process in the same manner as in Evaluation Test 1-2, and an SEM image was taken to observe the state of the SiGe film 90 after etching.

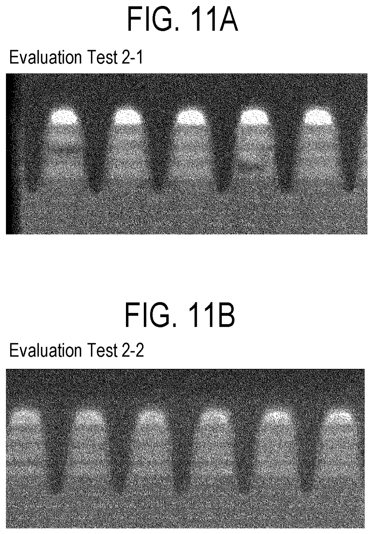

FIGS. 11A and 11B show the results of Evaluation Test 2. In Evaluation Test 2-1, it was confirmed that the SiGe film 90 was etched from the side, but in Evaluation Test 2-2, etching of the SiGe film 90 was not confirmed. Thus, it may be seen that in Evaluation Test 2-2, the passage of the etching gas via the pores of the porous film 93 was suppressed. Based on the results of Evaluation Test 2, it is believed that when etching the wafer W shown in FIG. 1 according to the procedure described with reference to FIG. 7 in the embodiment, the SiGe film 13 may be etched while suppressing the etching of the semiconductor film 16.

### [Evaluation Test 3]

In Evaluation Test 3, substrates each having a B-SiGe film and a SiGe film formed thereon were prepared. Using an etching apparatus substantially similar to that shown in FIG. 6, an etching gas was supplied according to the procedure described with reference to the chart in FIG. 7 to perform the etching process on these films. This etching process was performed under different processing conditions for each substrate. Specifically, the combination of the flow rate ratio of the HF gas to the F₂ gas supplied to the tank 81, the internal pressure of the processing container 20 during processing, and the like was changed for each substrate. Further, the etching amount of each film was measured after the etching process. In processing the substrates in Evaluation Test 3, the flow rate of the N₂ gas supplied into the processing container 20 was constant immediately before and while the valve V1 is opened.

In a processing condition 1, the flow rate ratio of the HF gas to the F₂ gas was set to 1:2. When a selectivity is assumed as a value obtained by dividing the etching amount of the SiGe film by the etching amount of the B-SiGe film, the selectivity for the substrate processed under the processing condition 1 was 250 or more. In a processing condition 2, the flow rate ratio of the HF gas to the F₂ gas was set to 1:6. For the substrate processed under the processing condition 2, the selectivity was 30 to 60. In a processing condition 3, the flow rate ratio of the HF gas to the F₂ gas was set to 1:2 similar to the processing condition 1. However, the internal pressure of the processing container 20 under the processing condition 3 is different from the internal pressure of the processing container 20 under the processing condition 1. For the substrate processed under the processing condition 3, the selectivity was 70 to 85. In a processing condition 4, the flow rate ratio of the HF gas to the F₂ gas was set to 1:6 similar to the processing condition 2. However, the internal pressure of the processing container 20 under the processing condition 4 was different from the internal pressure of the processing container 20 under the processing condition 2. For the substrate processed under the processing condition 4, the selectivity was 20 to 50. In a processing condition 5, the flow rate ratio of the HF gas to the F₂ gas was set to 1:10. For the substrate processed under the processing condition 5, the selectivity was 10 to 65.

From the results of Evaluation Test 3, it is believed that when the semiconductor film 16 is the B-SiGe film, as described in the embodiment, the SiGe film 13 may be more selectively etched while suppressing the etching of the semiconductor film 16. It may be seen that a sufficiently high selectivity is obtained under each of the processing conditions 1 to 6.

### EXPLANATION OF REFERENCE NUMERALS

- V1: Valve
- W: Wafer
- 12: Si film
- 13: SiGe film
- 14: Porous film
- 16: Semiconductor film
- 20: Processing container
- 63: Pipe
- 81: Tank

## Claims

1. An etching method, comprising:
exhausting a processing container in which a substrate is accommodated, wherein the substrate includes a first film, a porous film and a second film formed therein, each of the first film and the porous film being exposed from a surface of the substrate and the second film being not exposed from the surface of the substrate by being coated with the porous film;
supplying, by a gas source, an etching gas having an etching property with respect to the first film and the second film to a gas supply path;
storing the etching gas in a reservoir provided in the gas supply path to increase an internal pressure of an interior of the reservoir; and
selectively etching the first film among the first film and the second film by opening a valve provided downstream of the reservoir in the gas supply path to supply the etching gas stored in the reservoir to the interior of the processing container.

2. The etching method of Claim 1, wherein the selectively etching is repeatedly performed on the substrate by repeatedly opening/closing the valve.

3. The etching method of Claim 2, further comprising:
changing an opening degree of an exhaust valve in an exhaust path configured to exhaust the interior of the processing container; and
setting the internal pressure of the processing container, during a period from when the exhaust valve is closed to when the exhaust valve is subsequently opened, to be lower than the internal pressure of the processing container at each time the exhaust valve is opened.

4. The etching method of Claim 1, further comprising:
supplying an inert gas to the interior of the processing container; and
setting a flow rate of the inert gas supplied to the interior of the processing container, while the valve is closed, to be greater than a flow rate of the inert gas supplied to the interior of the processing container while the valve is opened.

5. The etching method of Claim 1, wherein the first film and the second film are silicon-containing films.

6. The etching method of Claim 5, wherein the first film is a silicon germanium film.

7. The etching method of Claim 6, wherein a silicon film is formed to be adjacent to the silicon germanium film, and
wherein the etching gas is a gas for selectively etching the silicon germanium film among the silicon germanium film and the silicon film.

8. The etching method of Claim 7, wherein the porous film is provided between the silicon germanium film and the second film while being adjacent to the silicon germanium film and the second film, and
wherein a direction in which the silicon germanium film and the porous film are aligned intersects a direction in which the silicon germanium film and the silicon film are aligned.

9. The etching method of Claim 6, wherein the second film is a silicon germanium film doped with boron.

10. An etching apparatus, comprising:
a processing container in which a substrate is accommodated and whose interior is configured to be exhausted, wherein the substrate includes a first film, a porous film and a second film formed therein, each of the first film and the porous film being exposed from a surface of the substrate and the second film being not exposed from the surface of the substrate by being coated with the porous film;
a gas supply path configured to supply an etching gas having an etching property with respect to the first film and the second film from a gas source to the interior of the processing container;
a reservoir provided in the gas supply path and configured to store the etching gas; and
a valve provided downstream of the reservoir in the gas supply path and configured to be closed to increase a pressure of the interior of the processing container by the etching gas stored in the reservoir to the interior of the processing container and to be open to supply the etching gas stored in the reservoir to the interior of the processing container such that the first film among the first film and the second film is selectively etched.
